# EUROPEAN PATENT SPECIFICATION

(11) **EP 3 307 038 B1**
(45) Date of publication and mention of the grant of the patent: **10.11.2021**
(21) Application number: 17167405.4
(22) Date of filing: 20.04.2017
(51) Int. Cl.: H05K 7/14

(54) **SLIDE RAIL ASSEMBLY**
GLEITSCHIENENANORDNUNG
ENSEMBLE DE RAIL DE GLISSEMENT

(30) Priority: 05.10.2016 TW 105132507
(43) Date of publication of application: 11.04.2018
(73) Proprietor: King Slide Works Co., Ltd., Kaohsiung City 821 (TW); King Slide Technology Co., Ltd., Kaohsiung City 82151 (TW)
(72) Inventor: Chen, Ken-Ching, Kaohsiung City 821 (TW); Yang, Shun-Ho, Kaohsiung City 821 (TW); Chang, Wei-Chen, Kaohsiung City 821 (TW); Wang, Chun-Chiang, Kaohsiung City 821 (TW)
(74) Representative: Straus, Alexander

(56) References cited:
- EP-A1- 2 989 930
- US-A1- 2005 017 614
- US-A1- 2006 029 304
- US-A1- 2013 259 410

## Description

### Field of the Invention

The present invention is related to a slide rail assembly.

### Background of the Invention

A three-section slide rail assembly comprises a first rail, a second rail and a third rail. Wherein, the second rail is configured to extend a traveling distance of the third rail relative to the first rail, and the third rail is usually configured to mount a carried object.

When the third rail carries the carried object to move along a direction relative to the second rail and the first rail, strength of the third rail for carrying the carried object may not be enough due to the carried object being overweight, so as to deform or damage the third rail during long term use.

On the other hand, US patent number US 6, 938, 967 B2 of Dubon et al. discloses a drop-in mounting method for mounting a carried object (such as a chassis) to a slide rail assembly. According to the mounting method, the slide rail assembly needs to be completely pulled out of a rack, and then the chassis is lifted to be higher than the slide rail assembly. Thereafter, a plurality of mounting posts at both sides of the chassis are respectively aligned to a plurality of mounting features of the slide rail assembly to be further dropped therein, so as to mount the chassis to the slide rail assembly. The aforementioned mounting method is usually used to mount the chassis in a limited space, and rails of the slide rail assembly are not detachable from each other. However, the aforementioned mounting method has some drawbacks. For example, when the slide rail assembly is located near a top position of the rack, it is inconvenient to lift the chassis to be higher than the slide rail assembly during a process of mounting the chassis to the slide rail assembly.

US patent number US 8,622,492 B2 of Chen et al. discloses another method for mounting a carried object (such as a chassis) to a slide rail assembly. According to the mounting method, a rail (such as an inner rail) of the slide rail assembly is required to be pulled out and detached from the slide rail assembly, in order to mount the inner rail to a side of the chassis . Thereafter, the chassis is mounted to the slide rail assembly by inserting the inner rail into the slide rail assembly. Such mounting method requires a larger space than the mounting method of the previous patent does, and is not applicable to a smaller room. An advantage of Chen's mounting method is that when the slide rail assembly is located near the top position of the rack, the chassis can be mounted to the slide rail assembly by aligning and inserting the inner rail to the slide rail assembly without lifting the chassis to be higher than the slide rail assembly.

Each of the two mounting methods has its drawback. The present invention combines the advantages of both mounting methods to provide more product options in the industry.

US 2005/0017614 A1 discloses a slide assembly including at least a first slide segment and a second slide segment. A bearing assembly is provided between the segments to facilitate sliding movement therebetween. A split lock arm attached to the first slide segment includes a first arm and a second arm. The first arm has a notch, and the second arm has a notch and an angled portion. The notches receive and lock a stop of the second slide segment when the second slide segment is moved to a fully extended state relative to the first slide segment. The second slide segment is releasable from the fully extended state by actuating a spring-biased release member such that the release member engages the angled portion of the second arm. The release member is configured to bias the second arm such that the notch is moved out of alignment with the stop. Accordingly, retraction of the second slide within the first slide is permitted. Simultaneously, the notch on the first arm remains in alignment with the stop and prevents unintentional removal of the second slide segment from the first slide segment.

US 2013/0259410 A1 discloses slide assemblies that include at least an inner slide segment and an outer slide segment. Many of the slide assemblies also include an intermediate slide segment interposed between the inner slide segment and the outer slide segment. The outer slide segment is constructed from a bent piece of material having a substantially uniform wall thickness . The outer slide segment is formed to have a wall portion, an upper portion and a lower portion. Each of the upper portion and lower portion include two layers of the piece of material. A mounting assembly for a slide assembly includes at least one bracket having a first pin and a second pin movable relative to the first pin. The second pin can surround and slide upon the first pin and can be biased to a first position and movable to a second position relative to the first pin.

EP 2 989 930 A1 discloses a slide rail assembly includes a first rail having a guiding portion, a second rail, a third rail having a hook portion, and an actuating member movably connecting to the second rail and having a contact portion. When the third rail is pulled with respect to the first rail with the contact portion engaging with the hook portion, the second rail synchronously moves along with the third rail to be moved to a predetermined position with respect to the first rail, and consequently, the actuating member rotates by an angle by guiding means of the guiding portion of the first rail to disengage the contact portion of the actuating member from the hook portion of the third rail.

US 2006/0029304 A1 discloses a synchronous system for a three-stage ball bearing slide includes a carrier track being inserted into a fixed track to carry a mobile track. Both of the mobile and the carrier tracks engage in reciprocal movement along the same axis direction in relation to the fixed track. A dancer is pivoted to the rear end of the carrier track. The carrier track synchronously slides with the mobile track by a protruding tongue on the mobile track upholding the dancer, and is held in position by having the dancer to uphold a compression bit on the fixed track. A direct push on the extreme where the carrier track is extended releases the dancer from the compression bit to retract once again the carrier track into the fixed track.

### Summary of the Invention

This in mind, the present invention aims at providing a slide rail assembly.

This is achieved by a slide rail assembly according to the claim 1. The dependent claims pertain to corresponding further developments and improvements.

As will be seen more clearly from the detailed description following below, the claimed slide rail assembly comprises a first rail, a second rail, a third rail and an engaging member. The first rail comprises a releasing feature. The second rail is movable relative to the first rail. The third rail is movable relative to the second rail. The engaging member is pivoted to the second rail. Wherein, the engaging member engages with the third rail to allow the second rail and the third rail to be synchronously moved relative to the first rail along a first direction, and the releasing feature disengages the engaging member from the third rail when the second rail is synchronously moved with the third rail relative to the first rail to a predetermined position. The third rail has a plurality of mounting holes spaced from each other, and the third rail comprises an extension feature for defining a vertical hole part and a longitudinal hole part of the mounting hole. The longitudinal hole part is communicated with the vertical hole part. A sliding auxiliary device is arranged between the second rail and the third rail. The sliding auxiliary device comprises a holding base and a plurality of rolling members arranged on the holding base. The plurality of rolling members are in rolling contact with the second rail and the third rail. A first operating piece is mounted to the third rail. The first operating piece is operatively switched between a first working state and a second working state. The second rail comprises a blocking feature having a blocking section. When the engaging member is disengaged from the third rail by the releasing feature, and the third rail is moved relative to the second rail along the first direction to an extension position, the first operating piece abuts against one side of the blocking section of the blocking feature in the first working state. The second rail has a first aperture and the sliding auxiliary device has a second aperture . When the third rail is located at the extension position, the first aperture, the second aperture and one of the mounting holes of the third rail are communicated with each other. When the first operating piece is operatively switched from the first working state to the second working state, the third rail is detachable from the second rail along the first direction.

### Brief Description of the Drawings

In the following, the invention is further illustrated by way of example, taking reference to the accompanying drawings thereof:
FIG. 1 is a diagram showing slide rail assemblies configured to mount a carried object to a rack according to an embodiment of the present invention;
FIG. 2 is an exploded view of the slide rail assembly comprising a first rail, a second rail and a third rail according to an embodiment of the present invention;
FIG. 3 is an enlarged view of an area A of FIG. 2;
FIG. 4 is an enlarged view of an area B of FIG. 2;
FIG. 5 is an enlarged view of an area C of FIG. 2;
FIG. 6 is a diagram showing the third rail of the slide rail assembly according to an embodiment of the present invention;
FIG. 6A is an enlarged view of an area A of FIG. 6;
FIG. 6B is an enlarged view of an area B of FIG. 6;
FIG. 7 is a cross-sectional view of the third rail of the slide rail assembly according to an embodiment of the present invention;
FIG. 8 is a diagram showing the slide rail assembly in a retracted state according to an embodiment of the present invention;
FIG. 9 is a diagram showing the second rail and the third rail of the slide rail assembly being synchronously moved relative to the first rail along a first direction according to an embodiment of the present invention;
FIG. 10 is a diagram showing an engaging member of the slide rail assembly being moved along a releasing feature according to an embodiment of the present invention;
FIG. 11 is an enlarged view of an area A of FIG. 10;
FIG. 12 is a diagram showing the second rail of the slide rail assembly being no longer synchronously moved with the third rail according to an embodiment of the present invention;
FIG. 13 is an enlarged view of an area A of FIG. 12;
FIG. 14 is a diagram showing the engaging member of the slide rail assembly being blocked by the releasing feature in a state according to an embodiment of the present invention;
FIG. 15 is an enlarged view of an area A of FIG. 14;
FIG. 16 is a diagram showing the third rail of the slide rail assembly being moved relative to the second rail along a second direction and contacting the engaging member according to an embodiment of the present invention;
FIG. 17 is a diagram showing the third rail of the slide rail assembly configured to drive the engaging member to be no longer blocked by the releasing member according to an embodiment of the present invention;
FIG. 18 is an enlarged view of an area A of FIG. 17;
FIG. 19 is a diagram showing the third rail of the slide rail assembly in the retracted state relative to the second rail according to an embodiment of the present invention;
FIG. 20 is a diagram showing the third rail of the slide rail assembly being moved relative to the second rail along the first direction to drive a sliding auxiliary device to move according to an embodiment of the present invention;
FIG. 21 is a diagram showing the third rail of the slide rail assembly being moved relative to the second rail along the first direction to drive the sliding auxiliary device to move according to an embodiment of the present invention;
FIG. 22 is a diagram showing a blocking feature configured to block a first operating piece when the third rail of the slide rail assembly is moved relative to the second rail along the first direction to a position according to an embodiment of the present invention;
FIG. 23 is a diagram showing the first operating piece being no longer blocked by the blocking feature according to an embodiment of the present invention;
FIG. 24 is a diagram showing the third rail of the slide rail assembly being detached from the second rail according to an embodiment of the present invention;
FIG. 25 is a diagram showing the blocking feature configured to block a second operating piece when the third rail of the slide rail assembly is moved to the position according to an embodiment of the present invention;
FIG. 26 is a diagram showing the second operating piece of the slide rail assembly being no longer blocked by the blocking feature according to an embodiment of the present invention;
FIG. 27 is a diagram showing the slide rail assembly in an extended state and the third rail configured to mount a carried object according to an embodiment of the present invention;
FIG. 28 is an enlarged view of an area A of FIG. 27;
FIG. 29 is a diagram showing the carried being mounted to the third rail of the slide rail assembly according to an embodiment of the present invention; and
FIG. 30 is a diagram showing the carried object being mounted to the third rail with the third rail being going to be mounted to the second rail according to an embodiment of the present invention.

### Detailed Description

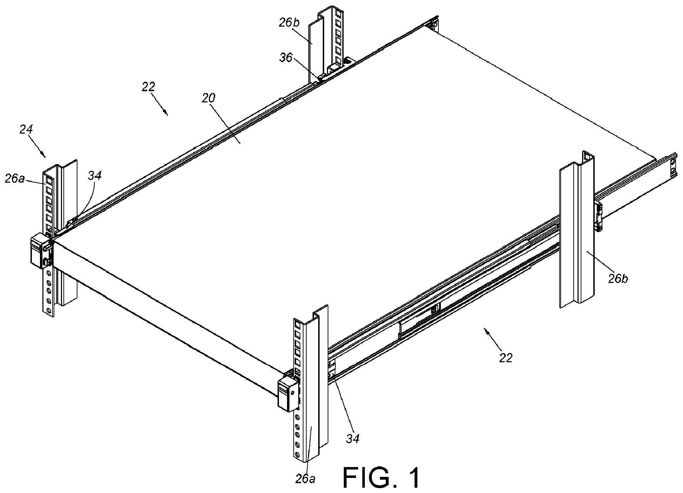

As shown in FIG. 1, a carried object 20 is mounted to a rack 24 through a pair of slide rail assemblies 22. The carried object 20 can be an electronic apparatus or a chassis. The rack 24 comprises a pair of first post 26a and a pair of second post 26b. Wherein, two portions of each of the slide rail assemblies 22 are respectively mounted to the first post 26a and the second post 26b through a first bracket device 34 and a second bracket device 36. Such arrangement is well known to those skilled in the art. For simplification, no further illustration is provided.

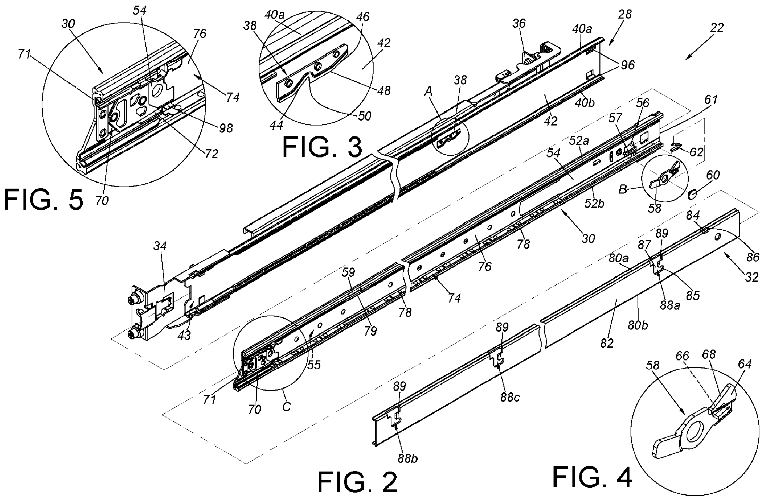

As shown in FIG. 2, the slide rail assembly 22 comprises a first rail 28, a second rail 30 and a third rail 32. The first rail 28 is arranged with the first bracket device 34 and the second bracket device 36. The first rail 28 comprises a releasing feature 38. The releasing feature 38 can be an additional component mounted to the first rail 28; or the releasing feature 38 can be integrally formed on the first rail 28. Furthermore, the first rail 28 comprises a first wall 40a, a second wall 40b, and a side wall 42 connected between the first wall 40a and the second wall 40b. A first passage 43 is defined by the first wall 40a, the second wall 40b and the side wall 42 of the first rail 28.

In the present embodiment, the releasing feature 38 is arranged on the side wall 42 of the first rail 28. Preferably, as shown in FIG. 3, the releasing feature 38 comprises a first guiding part 44, a second guiding part 46, a linear part 48 and a blocking part 50. The blocking part 50 and the linear part 48 are located between the first guiding part 44 and the second guiding part 46. Preferably, each of the first guiding part 44 and the second guiding part 46 has an inclined face or an arc face. The blocking part 50 has a wall located between the first guiding part 44 and the linear part 48. Wherein, the blocking part 50 is recessed relative to the linear part 48.

The second rail 30 (or called as middle rail) is movably mounted to the first rail 28 inside the first passage 43. In particular, the second rail 30 has a first wall 52a, a second wall 52b, and a side wall 54 connected between the first wall 52a and the second wall 52b. A second passage 55 is defined by the first wall 52a, the second wall 52b and the side wall 54 of the second rail 30. Preferably, the side wall 54 of the second rail 30 has a through hole 56 facing toward the side wall 42 of the first rail 28. The second rail 30 has a supporting wall 57 adjacent to the through hole 56. In addition, the second rail 30 has a first aperture 59. In the present embodiment, the first aperture 59 is arranged on the first wall 52a. Furthermore, the slide rail assembly 22 comprises an engaging member 58 movably mounted to the second rail 30. In the present embodiment, the engaging member 58 is pivoted to the side wall 54 of the second rail 30 by a pivoting member 60, and the engaging member 58 is adjacent to a rear end 61 of the second rail 30. The slide rail assembly 22 further comprises an elastic member 62 configured to provide an elastic force to the engaging member 58. For example, the elastic member 62 is mounted between the supporting wall 57 and the engaging member 58. As shown in FIG. 4, the engaging member 58 comprises an engaging part 64. Preferably, the engaging member 58 further comprises an extension part 66 and a disengaging part 68. Wherein, the extension part 66 is located at a position corresponding to the through hole 56 of the second rail 30. The disengaging part 68 has an inclined face or an arc face. The second rail 30 comprises a blocking feature 70. In the present embodiment, the blocking feature 70 is arranged on the side wall 54 and adjacent to a front end 71 of the second rail 30. The blocking feature 70 can be an additional component mounted to the second rail 30; or the blocking feature 70 can be integrally formed on the second rail 30. Furthermore, as shown in FIG. 5, the blocking feature 70 has a blocking section 72. The blocking section 72 is protruded relative to the side wall 54 of the second rail 30. In the invention, the slide rail assembly 22 further comprises a sliding auxiliary device 74 movably mounted to the second rail 30 inside the second passage 55. The sliding auxiliary device 74 comprises a holding base 76 and a plurality of rolling members 78 arranged on the holding base 76. The plurality of rolling members 78 can be balls or rollers. The holding base 76 of the sliding auxiliary device 74 has a second aperture 79. When the sliding auxiliary device 74 is moved to a position, the second aperture 79 is located at a position corresponding to the first aperture 59 of the second rail 30.

The third rail 32 (or called as inner rail) is movably mounted to the second rail 30 inside the second passage 55. In particular, the third rail 32 has a first wall 80a, a second wall 80b, and a side wall 82 connected between the first wall 80a and the second wall 80b. Preferably, the third rail 32 has an opening 84 and at least one rail wall 86 adjacent to the opening 84. In the present embodiment, the opening 84 is arranged on the first wall 80a. In addition, the third rail 32 has a plurality of mounting holes spaced from each other. In the present embodiment, the third rail 32 has a first mounting hole 88a, a second mounting hole 88b and a third mounting hole 88c. The mounting holes 88a, 88b, 88c are configured to mount the carried object 20. Wherein, at least one of the mounting holes 88a, 88b, 88c is substantially L-shaped or J-shaped. In the present embodiment, the mounting holes 88a, 88b, 88c have identical shapes, but the present invention is not limited thereto. Furthermore, the third rail 32 comprises a plurality of extension features 89. Each of the extension features 89 defines a vertical hole part 87 and a longitudinal hole part 85 of the corresponding mounting hole, wherein the vertical hole part 87 is communicated with the longitudinal hole part 85. The extension feature 89 can be a protrusion located between the vertical hole part 87 and the longitudinal hole part 85.

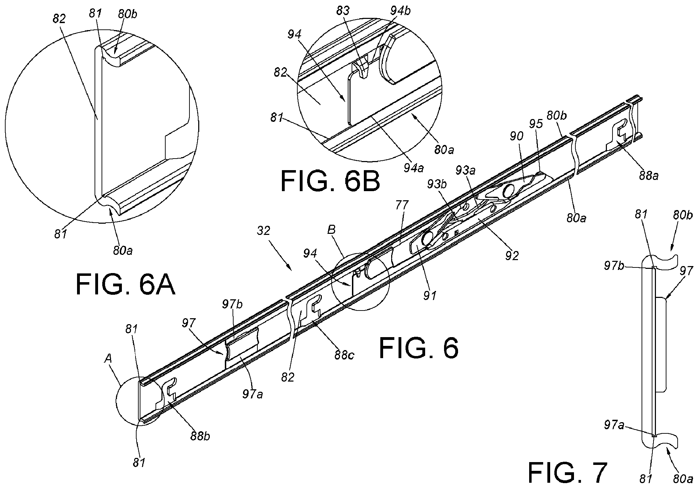

FIG. 6 is a diagram showing one side of the side wall 82 of the third rail 32 (such as an inner side or a side facing toward the second rail 30) . Compared with FIG. 2, FIG. 6 shows the first wall 80a, the second wall 80b and the mounting holes 88a, 88b, 88c of the third rail 32 in an upside down state. Furthermore, the slide rail assembly 22 further comprises a first operating piece 90 movably mounted to the third rail 32. The first operating piece 90 can be operated to be in different working states. In the present embodiment, the first operating piece 90 is pivoted to the third rail 32. Preferably, the slide rail assembly 22 further comprises a supporting base 92 mounted to the third rail 32. The supporting base 92 comprises a first elastic part 93a configured to provide an elastic force to one end of the first operating piece 90, so as to hold the first operating piece 90 in a first working state. Preferably, the first operating piece 90 can be operated through a first operating rod 94. The first operating rod 94 comprises a longitudinal rod part arranged substantially along a longitudinal direction of the third rail 32. The first operating rod 94 further comprises an actuating part 95 located at a position corresponding to another end of the first operating piece 90 for driving the first operating piece 90 to be no longer in the first working state. Preferably, as shown in FIG. 6 and FIG. 6A, at least one of the first wall 80a and the second wall 80b of the third rail 32 is arranged with a groove 81. In the present embodiment, both the first wall 80a and the second wall 80b are arranged with the grooves 81 respectively. Each of the grooves 81 is adjacent to the side wall 82, but the present invention is not limited thereto.

As shown in FIG. 6B, the first operating rod 94 has one side 94a partially located in the groove 81 of the first wall 80a of the third rail 32. An inverted L-shaped protrusion part 83 is arranged on the side wall 82 of the third rail 32 and configured to abut against another side 94b of the first operating rod 94 for preventing the first operating rod 94 from excessively tilting away from a plane of the side wall 82 of the third rail 32 due to tolerance or deformation.

As shown in FIG. 6, the slide rail assembly 22 further comprises a second operating piece 91 movably mounted, such as pivoted, to the third rail 32. The supporting base 92 further comprises a second elastic part 93b configured to provide an elastic force to one end of the second operating piece 91, so as to hold the second operating piece 91 in a first working state. Preferably, the slide rail assembly 22 further comprises a second operating rod 97 having a longitudinal rod part arranged substantially along the longitudinal direction of the third rail 32. Wherein, the second operating rod 97 comprises a driving part 77 corresponding to the second operating piece 91 for driving the second operating piece 91 to be no longer in the first working state. The second operating rod 97 has at least one side partially located in the groove 81 of the third rail 32. In the present embodiment, the second operating rod 97 has two sides 97a, 97b partially located in the grooves 81 of the third rail 32. (please also refer to FIG. 7).

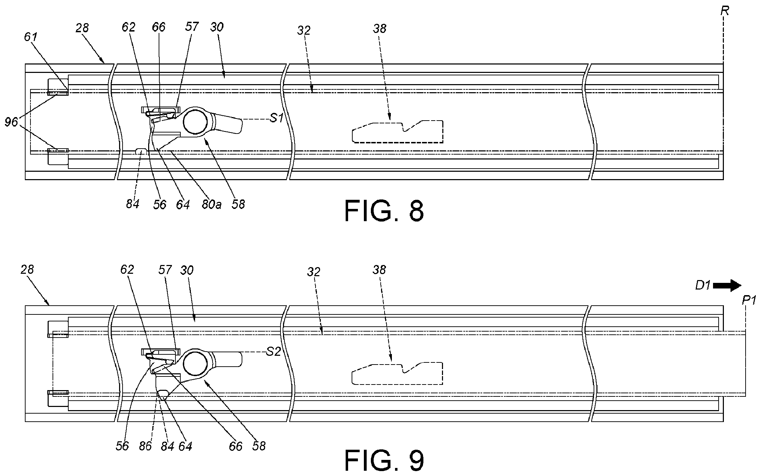

As shown in FIG. 8, the extension part 66 of the engaging member 58 penetrates through the through hole 56 of the second rail 30, and the elastic member 62 is arranged between the engaging member 58 and the supporting wall 57 of the second rail 30, so as to hold the engaging member 58 in a first state S1 relative to the second rail 30. Furthermore, when the slide rail assembly 22 is in a retracted state, the second rail 30 is located at a retracted position relative to the first rail 28, and the rear end 61 of the second rail 30 is located at a position corresponding to at least one rear stopper 96 of the first rail 28. On the other hand, the third rail 32 is also located at a retracted position R relative to the second rail 30. Wherein, the engaging member 58 is driven to abut against one of the first wall 80a and the second wall 80b of the third rail 32 by the elastic member 62. For example, the engaging member 58 is driven to abut against the first wall 80a and held in the first state S1 by the elastic member 62, and the elastic member 62 accumulates an elastic force.

As shown in FIG. 9, when the third rail 32 is moved relative to the second rail 30 from the retracted position R to a first predetermined position P1 along a first direction D1, the engaging member 58 is configured to engage with the third rail 32. In particular, when the third rail 32 is located at the first predetermined position P1 relative to the second rail 30, the engaging member 58 is rotated from the first state S1 to a second state S2 in response to the elastic force released by the elastic member 62, such that the engaging part 64 of the engaging member 58 enters the opening 84 of the third rail 32, and the engaging part 64 is located at a position corresponding to the at least one rail wall 86.

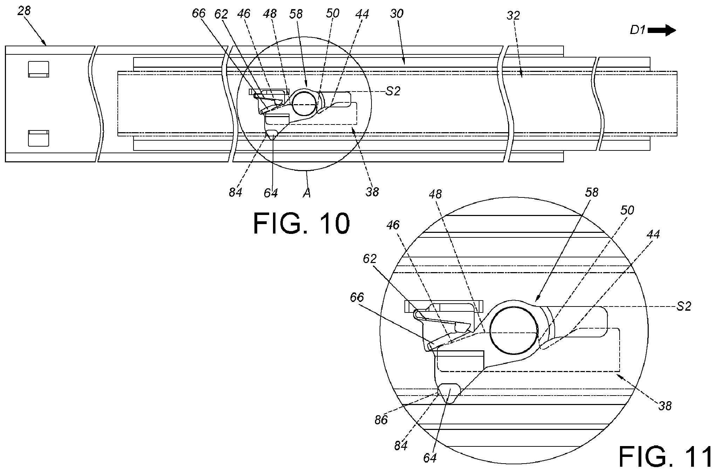

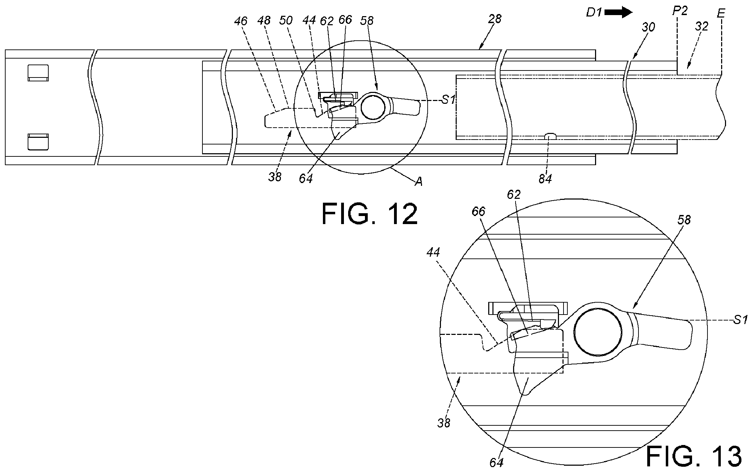

As shown in FIG. 10, FIG. 11 and FIG. 12, when the engaging member 58 is engaged with the third rail 32, the second rail 30 is driven by the third rail 32 to synchronously move. That is to say, the second rail 30 and the third rail 32 can be synchronously moved relative to the first rail 28 along the first direction D1. When the second rail 30 is synchronously moved with the third rail 32 to a second predetermined position P2, the releasing feature 38 of the first rail 28 is configured to disengage the engaging member 58 from the third rail 32. In particular, in a process of the second rail 30 being synchronously moved with the third rail 32, the extension part 66 of the engaging member 58 is moved along the second guiding part 46, the linear part 48, the blocking part 50 and the first guiding part 44 of the releasing feature 38. In particular, when the extension part 66 of the engaging member 58 sequentially passes through the second guiding part 46, the linear part 48 and the blocking part 50 until the second rail 30 is moved relative to the first rail 28 to the second predetermined position P2, the engaging member 58 is guided by the first guiding part 44 through the extension part 66 to be no longer in the second state S2. For example, the engaging member 58 is moved back to the first state S1 from the second state S2 (please also refer to FIG. 13), such that the engaging part 64 of the engaging member 58 is disengaged from the opening 84 of the third rail 32. After the engaging member 58 is disengaged from the third rail 32, the third rail 32 is able to be moved relative to the second rail 30 along the first direction D1 to an extension position E.

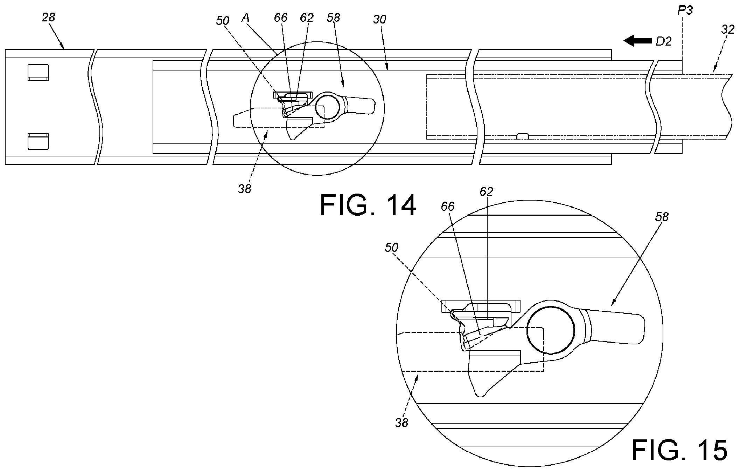

As shown in FIG. 12 and FIG. 14, when the second rail 30 is moved relative to the first rail 28 from the second predetermined position P2 to a third predetermined position P3 along a second direction D2 (opposite to the first direction D1), the extension part 66 of the engaging member 58 is blocked by the blocking part 50 of the releasing feature 38 (please also refer to FIG. 15) for preventing the second rail 30 from being moved relative to the first rail 28 along the second direction D2.

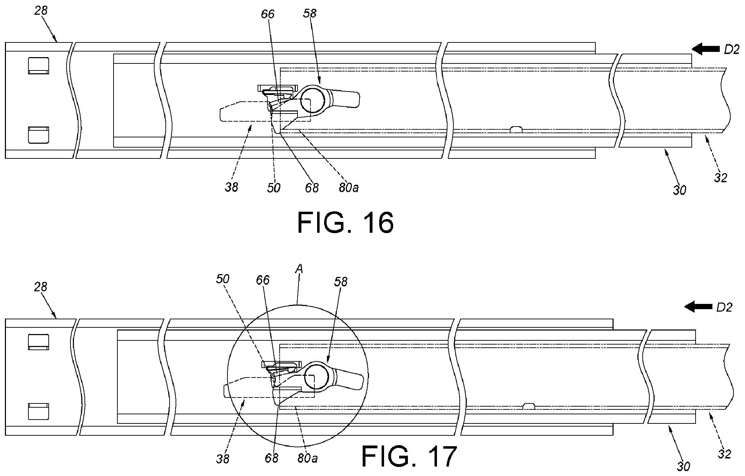

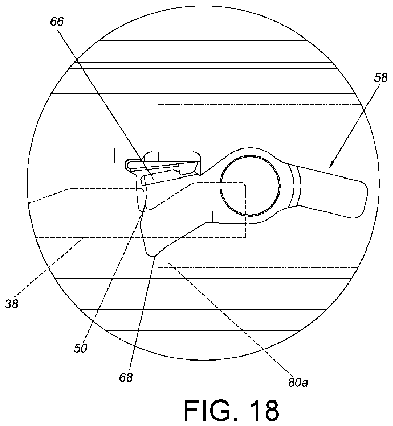

As shown in FIG. 16 and FIG. 17, when the extension part 66 of the engaging member 58 is blocked by the blocking part 50 of the releasing feature 38, and the third rail 32 is moved relative to the second rail 30 from the extension position E along the second direction D2, the third rail 32 is configured to drive the engaging member 58 for moving the extension part 66 of the engaging member 58 to be no longer blocked by the blocking part 50 of the releasing feature 38. In the present embodiment, the first wall 80a of the third rail 32 is configured to drive the engaging member 58 to rotate through the disengaging part 68, in order to detach the extension part 66 from the blocking part 50 of the releasing feature 38 (please also refer to FIG. 18), so as to allow the second rail 30 to be movable relative to the first rail 28 along the second direction D2.

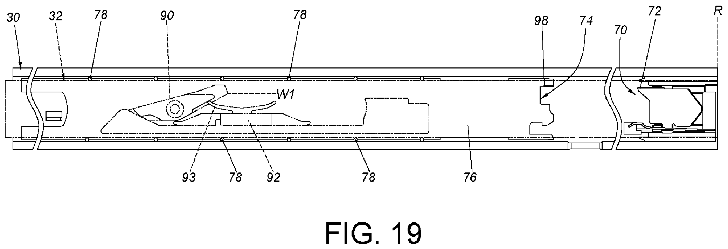

As shown in FIG. 19, the sliding auxiliary device 74 is arranged between the second rail 30 and the third rail 32 for improving smoothness of movement of the third rail 32 relative to the second rail 30. Wherein, the plurality of rolling members 78 on the holding base 76 are in rolling contact with the second rail 30 and the third rail 32. In addition, the holding base 76 comprises a contact part 98. Wherein, the contact part 98 and the blocking section 72 of the blocking feature 70 of the second rail 30 are not aligned along a longitudinal direction of the second rail 30. On the other hand, the first operating piece 90 corresponds to the contact part 98 of the holding base 76 when being in the first working state W1.

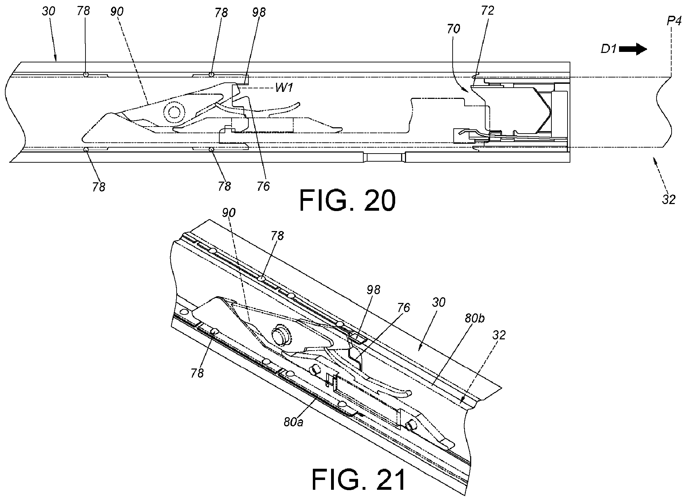

As shown in FIG. 20, when the engaging member 58 is disengaged from the third rail 32 to end the synchronous movement of the second rail 30 and the third rail 32 (please also refer to FIG. 12), the third rail 32 can be further moved relative to the second rail 30 along the first direction D1 (the first rail 28, the second operating piece 91 and the second operating rod 97 are omitted in the figure). When the third rail 32 is moved to a fourth predetermined position P4, the first operating piece 90 abuts against the contact part 98 of the holding base 76 in the first working state W1, in order to force the sliding auxiliary device 74 to synchronously move with the third rail 32 along the first direction D1 (please also refer to FIG. 21); or, the sliding auxiliary device 74 can be moved with the third rail 32 asynchronously along the first direction D1. The way of movement of the sliding auxiliary device 74 along the first direction D1 is not limited thereto. In addition, as shown in FIG. 21, the first wall 80a and the second wall 80b of the third rail 32 respectively contact the plurality of rolling members 78 of the holding base 76.

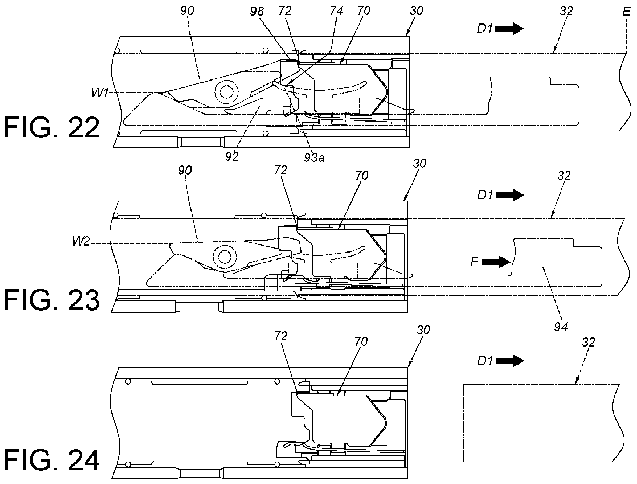

As shown in FIG. 22, when the third rail 32 is moved relative to the second rail 30 along the first direction D1 to the extension position E, the sliding auxiliary device 74 is driven by the first operating piece 90 to move to a position adjacent to the blocking feature 70 of the second rail 30. The first operating piece 90 abuts against a first side of the blocking section 72 of the blocking feature 70, such that the third rail 32 cannot be further moved relative to the second rail 30 along the first direction D1.

As shown in FIG. 23 and FIG. 24, in order to detach the third rail 32 from the second rail 30, a user can apply a force F along the first direction D1 to the first operating rod 94 for operating the first operating piece 90 to switch from the first working state W1 to a second working state W2. As such, the first operating piece 90 is no longer blocked by the blocking section 72 of the blocking feature 70. Therefore, the third rail 32 can be detached from the second rail 30 along the first direction D1. That is to say, the third rail 32 is detachably connected to the second rail 30.

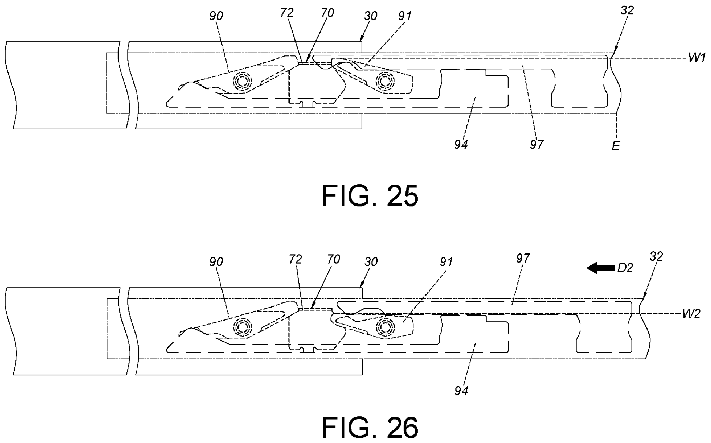

As shown in FIG. 25, in the present embodiment, when the third rail 32 is moved relative to the second rail 30 to the extension position E (the first rail 28 and the supporting base 92 are omitted in FIG. 25), the second operating piece 91 is in the first working state W1 and located at a second side of the blocking section 72 of the blocking feature 70. In such state, the third rail 32 is not movable relative to the second rail 30 along the second direction D2.

As shown in FIG. 26, in order to move the third rail 32 relative to the second rail 30 along the second direction D2 when the third rail 32 is located at the extension position E, the user can operate the second operating piece 91 through the second operating rod 97 to switch the second operating piece 91 from the first working state W1 to a second working state W2. As such, the second operating piece 91 is no longer located at the second side of the blocking section 72 of the blocking feature 70. Therefore the third rail 32 can be retracted relative to the second rail 30 from the extension position E along the second direction D2.

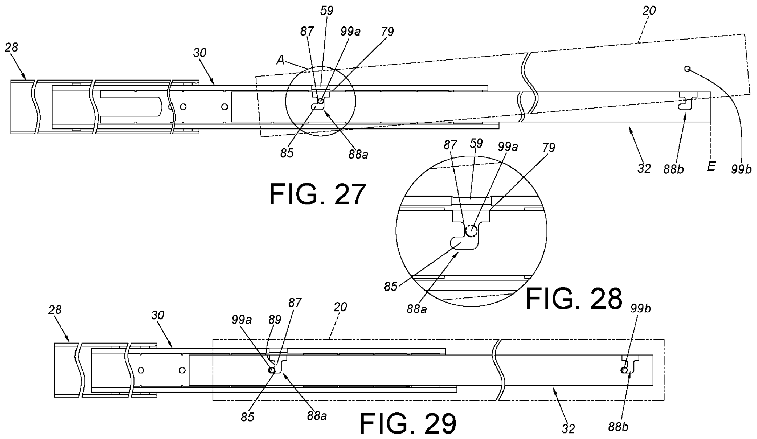

As shown in FIG. 27, the carried object 20 comprises a plurality of mounting parts, such as a first mounting part 99a and a second mounting part 99b. The plurality of mounting parts 99a, 99b can be mounted to the corresponding mounting holes 88a, 88b of the third rail 32. Furthermore, the slide rail assembly 22 of the present invention is configured to mount the carried object 20 in at least two different mounting ways.

In a first mounting way, when the second rail 30 and the third rail 32 are moved relative to the first rail 28 along the first direction D1, and the third rail 32 is located at the extension position E relative to the second rail 30, the first aperture 59, the second aperture 79 and one of the mounting holes of the third rail 32 (such as the first mounting hole 88a) are located at positions corresponding to each other, or communicated with each other (please also refer to FIG. 28) . Therefore, the user can take the carried object 20 to allow the first mounting part 99a of the carried object 20 to enter the longitudinal hole part 85 from the vertical hole part 87 of the first mounting hole 88a (please also refer to FIG. 29) . Thereafter, the other mounting part, such as the second mounting part 99b, is mounted to the second mounting hole 88b. Thus, the first aperture 59 of the second rail 30 and the vertical hole parts 87 of the plurality of mounting holes 88a, 88b are configured to mount the carried object 20 (such as the chassis).

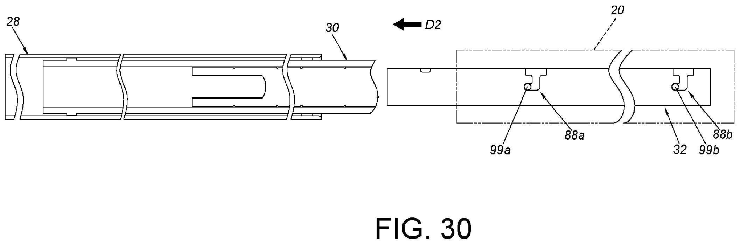

As shown in FIG. 30, in a second mounting way, after the third rail 32 is detached from the second rail 30, the user can take the carried object 20 to correspondingly mount the mounting parts 99a, 99b to the mounting holes 88a, 88b of the third rail 32. Thereafter, the carried object 20 can be mounted to the slide rail assembly 22 by mounting the third rail 32 to the second rail 30 along the second direction D2.

## Claims

1. A slide rail assembly (22), comprising:
a first rail (28) comprising a releasing feature (38);
a second rail (30) movable relative to the first rail (28);
a third rail (32) movable relative to the second rail (30); and
an engaging member (58) pivoted to the second rail (30);
wherein the engaging member (58) engages with the third rail (32) to allow the second rail (30) and the third rail (32) to be synchronously moved relative to the first rail (28) along a first direction, and the releasing feature (38) disengages the engaging member (58) from the third rail (32) when the second rail (30) is synchronously moved with the third rail (32) relative to the first rail (28) to a predetermined position;
wherein the third rail (32) has a plurality of mounting holes (88a, 88b, 88c) spaced from each other, and the third rail (32) comprises an extension feature (89) for defining a vertical hole part (87) and a longitudinal hole part (85) of the mounting hole (88a, 88b, 88c), the longitudinal hole part (85) is communicated with the vertical hole part (87);
wherein a sliding auxiliary device (74) is arranged between the second rail (30) and the third rail (32), the sliding auxiliary device (74) comprises a holding base (76) and a plurality of rolling members (78) arranged on the holding base (76), the plurality of rolling members (78) are in rolling contact with the second rail (30) and the third rail (32);
wherein a first operating piece (90) is mounted to the third rail (32), the first operating piece (90) is operatively switched between a first working state and a second working state, the second rail (30) comprises a blocking feature (70) having a blocking section (72), when the engaging member (58) is disengaged from the third rail (32) by the releasing feature (38), and the third rail (32) is moved relative to the second rail (30) along the first direction to an extension position, the first operating piece (90) abuts against one side of the blocking section (72) of the blocking feature (70) in the first working state;
wherein the second rail (30) has a first aperture (59) and the sliding auxiliary device (74) has a second aperture (79), when the third rail (32) is located at the extension position, the first aperture (59), the second aperture (79) and one of the mounting holes (88a, 88b, 88c) of the third rail (32) are communicated with each other, and when the first operating piece (90) is operatively switched from the first working state to the second working state, the third rail (32) is detachable from the second rail (30) along the first direction.

2. The slide rail assembly of claim 1, **characterized in that**
when the third rail (32) is moved relative to the second rail (30) along the first direction from a retracted position to a first predetermined position, the engaging member (58) engages with the third rail (32) to allow the second rail (30) and the third rail (32) to be synchronously moved relative to the first rail (28) along the first direction;
when the second rail (30) is synchronously moved with the third rail (32) relative to the first rail (28) along the first direction to a second predetermined position, the releasing feature (38) disengages the engaging member (58) from the third rail (32) to allow the third rail (32) to be moved relative to the second rail (30) along the first direction to the extension position.

3. The slide rail assembly of claim 2, **characterized in that** the slide rail assembly (22) further comprises an elastic member (62) providing an elastic force to the engaging member (58), and when the third rail (32) is located at the retracted position relative to the second rail (30), the engaging member (58) abuts against the first wall (80a) to be held in a first state in response to the elastic force of the elastic member (62).

4. The slide rail assembly of claim 3, **characterized in that** the third rail (32) has an opening (84) and a rail wall (86) adjacent to the opening (84), the engaging member (58) comprises an engaging part (64), and when the third rail (32) is located at the first predetermined position relative to the second rail (30), the engaging member (58) is rotated relative to the second rail (30) from the first state to a second state in response to the elastic force of the elastic member (62), such that the engaging part (64) enters the opening (84) to correspond to the rail wall (86).

5. The slide rail assembly any of claims 2-4, **characterized in that** the second rail (30) has a through hole (56) facing toward the first rail (28), the engaging member (58) comprises an extension part (66) passing through the through hole (56), the releasing feature (38) comprises a first guiding part (44), when the second rail (30) is synchronously moved with the third rail (32) along the first direction to the second predetermined position, the engaging member (58) is guided by the first guiding part (44) through the extension part (66) to be no longer in the second state, so as to allow the engaging member (58) to be disengaged from the third rail (32), the first guiding part (44) has an inclined face or an arc face.

6. The slide rail assembly of claim 5, **characterized in that** the releasing feature (38) further comprises a blocking part (50), when the second rail (30) is moved relative to the first rail (28) from the second predetermined position to a third predetermined position along a second direction opposite to the first direction, the extension part (66) of the engaging member (58) is blocked by the blocking part (50) for preventing the second rail (30) from being moved relative to the first rail (28) along the second direction.

7. he slide rail assembly of claim 6, **characterized in that** during a process of the third rail (32) being moved relative to the second rail (30) along the second direction from the extension position, the third rail (32) drives the engaging member (58) for moving the extension part (66) of the engaging member (58) to be no longer blocked by the blocking part (50).

8. The slide rail assembly of claim 6 or 7, **characterized in that** the releasing feature (38) further comprises a second guiding part (46) and a linear part (48), the blocking part (50) and the linear part (48) are located between the first guiding part (44) and the second guiding part (46), wherein the blocking part (50) has a wall located between the first guiding part (44) and the linear part (48), the second guiding part (46) has an inclined face or an arc face.

## Patentansprüche

1. Gleitschienenaufbau (22), welcher umfasst:
eine erste Schiene (28) mit einer Freigabeeinrichtung (38);
eine zweite Schiene (30), die relativ zu der ersten Schiene (28) beweglich ist;
eine dritte Schiene (32), die relativ zur zweiten Schiene (30) beweglich ist; und
ein Eingriffselement (58), das schwenkbar an der zweiten Schiene (30) angebracht ist;
wobei das Eingriffselement (58) in die dritte Schiene (32) eingreift, um zu ermöglichen, dass die zweite Schiene (30) und die dritte Schiene (32) relativ zu der ersten Schiene (28) entlang einer ersten Richtung synchron bewegt werden kann, und die Freigabeeinrichtung (38) das Eingriffselement (58) von der dritten Schiene (32) löst, wenn die zweite Schiene (30) synchron mit der dritten Schiene (32) relativ zu der ersten Schiene (28) in eine bestimmte Position bewegt wird;
worin die dritte Schiene (32) mehrere Befestigungslöcher (88a, 88b, 88c) aufweist, die voneinander beabstandet sind, und die dritte Schiene (32) ein Verlängerungsmerkmal (89) zum Definieren eines vertikalen Lochteils (87) und eines Längslochteils (85) des Befestigungslochs (88a, 88b, 88c) umfasst, wobei das Längslochteil (85) mit dem vertikalen Lochteil (87) in Verbindung steht;
worin eine Gleithilfseinrichtung (74) zwischen der zweiten Schiene (30) und der dritten Schiene (32) angeordnet ist, die Gleithilfseinrichtung (74) eine Haltebasis (76) und mehrere Rollelemente (78) umfasst, die auf der Haltebasis (76) angeordnet sind, und worin die mehreren Rollelemente (78) mit der zweiten Schiene (30) und der dritten Schiene (32) in Rollkontakt stehen;
worin ein erstes Betätigungselement (90) an der dritten Schiene (32) angebracht ist, wobei das erste Betätigungselement (90) betreibbar zwischen einem ersten Arbeitszustand und einem zweiten Arbeitszustand umgeschaltet werden kann, worin die zweite Schiene (30) ein Blockiermerkmal (70) mit einem Blockierabschnitt (72) umfasst, wobei wenn das Eingriffselement (58) durch die Freigabeeinrichtung (38) von der dritten Schiene (32) gelöst wird und die dritte Schiene (32) relativ zu der zweiten Schiene (30) entlang der ersten Richtung in eine Erstreckungsposition bewegt wird, das erste Betätigungselement (90) in dem ersten Arbeitszustand gegen eine Seite des Blockierabschnitts (72) des Blockiermerkmals (70) anstößt;
worin die zweite Schiene (30) eine erste Öffnung (59) und die Gleithilfseinrichtung (74) eine zweite Öffnung (79) aufweist, wobei wenn sich die dritte Schiene (32) in der Erstreckungsposition befindet, die erste Öffnung (59), die zweite Öffnung (79) und eines der Befestigungslöcher (88a, 88b, 88c) der dritten Schiene (32) miteinander in Verbindung stehen, und wenn das erste Betätigungselement (90) von dem ersten Arbeitszustand in den zweiten Arbeitszustand betreibbar umgeschaltet wird, die dritte Schiene (32) von der zweiten Schiene (30) entlang der ersten Richtung entfernbar ist.

2. Gleitschienenaufbau nach Anspruch 1, **dadurch gekennzeichnet, dass**
wenn die dritte Schiene (32) relativ zu der zweiten Schiene (30) entlang der ersten Richtung aus einer zurückgezogenen Position in eine erste bestimmte Position bewegt wird, das Eingriffselement (58) mit der dritten Schiene (32) in Eingriff kommt, um zu ermöglichen, dass die zweite Schiene (30) und die dritte Schiene (32) relativ zu der ersten Schiene (28) entlang der ersten Richtung synchron bewegt werden; und
wenn die zweite Schiene (30) relativ zur ersten Schiene (28) entlang der ersten Richtung synchron mit der dritten Schiene (32) in eine zweite bestimmte Position bewegt wird, die Freigabeeinrichtung (38) das Eingriffselement (58) von der dritten Schiene (32) löst, damit die dritte Schiene (32) relativ zur zweiten Schiene (30) entlang der ersten Richtung in die Erstreckungsposition bewegt werden kann.

3. Gleitschienenaufbau nach Anspruch 2, **dadurch gekennzeichnet, dass** der Gleitschienenaufbau (22) ferner ein elastisches Element (62) umfasst, das eine elastische Kraft auf das Eingriffselement (58) ausübt, und wenn sich die dritte Schiene (32) relativ zur zweiten Schiene (30) in der zurückgezogenen Position befindet, das Eingriffselement (58) an der ersten Wand (80a) anliegt, um als Reaktion auf die elastische Kraft des elastischen Elements (62) in einem ersten Zustand gehalten zu werden.

4. Gleitschienenaufbau nach Anspruch 3, **dadurch gekennzeichnet, dass** die dritte Schiene (32) eine Öffnung (84) und eine an die Öffnung (84) angrenzende Schienenwand (86) aufweist, das Eingriffselement (58) ein Eingriffsteil (64) umfasst, und dass, wenn sich die dritte Schiene (32) in der ersten bestimmten Position relativ zu der zweiten Schiene (30) befindet, das Eingriffselement (58) als Reaktion auf die elastische Kraft des elastischen Elements (62) relativ zur zweiten Schiene (30) aus dem ersten Zustand in einen zweiten Zustand gedreht wird, so dass das Eingriffsteil (64) in die Öffnung (84) eintritt, um mit der Schienenwand (86) zu korrespondieren.

5. Gleitschienenaufbau nach einem der Ansprüche 2 bis 4, **dadurch gekennzeichnet, dass** die zweite Schiene (30) ein Durchgangsloch (56) aufweist, das der ersten Schiene (28) zugewandt ist, das Eingriffselement (58) ein Verlängerungsteil (66) umfasst, das durch das Durchgangsloch (56) hindurchgeht, die Freigabeeinrichtung (38) ein erstes Führungsteil (44) umfasst, und dadurch dass wenn die zweite Schiene (30) mit der dritten Schiene (32) entlang der ersten Richtung zu der zweiten bestimmten Position synchron bewegt wird, das Eingriffselement (58) durch das erste Führungsteil (44) durch das Verlängerungsteil (66) geführt wird, um nicht mehr in dem zweiten Zustand zu sein, so dass das Eingriffselement (58) von der dritten Schiene (32) außer Eingriff kommen kann, und dadurch dass das erste Führungsteil (44) eine geneigte Fläche oder eine Bogenfläche aufweist.

6. Gleitschienenaufbau nach Anspruch 5, **dadurch gekennzeichnet, dass** die Freigabeeinrichtung (38) ferner ein Blockierteil (50) umfasst, und wenn die zweite Schiene (30) relativ zur ersten Schiene (28) entlang einer zweiten Richtung entgegengesetzt zur ersten Richtung von der zweiten bestimmten Position zu einer dritten bestimmten Position bewegt wird, das Verlängerungsteil (66) des Eingriffselements (58) durch das Blockierteil (50) blockiert wird, um zu verhindern, dass die zweite Schiene (30) relativ zur ersten Schiene (28) entlang der zweiten Richtung bewegt wird.

7. Gleitschienenaufbau nach Anspruch 6, **dadurch gekennzeichnet, dass** während eines Vorgangs, bei dem die dritte Schiene (32) relativ zu der zweiten Schiene (30) entlang der zweiten Richtung aus der Erstreckungsposition bewegt wird, die dritte Schiene (32) das Eingriffselement (58) antreibt, um das Verlängerungsteil (66) des Eingriffselements (58) zu bewegen, nicht mehr durch das Blockierteil (50) blockiert zu sein.

8. Gleitschienenaufbau nach Anspruch 6 oder 7, **dadurch gekennzeichnet, dass** die Freigabeeinrichtung (38) ferner ein zweites Führungsteil (46) und ein lineares Teil (48) umfasst, das Blockierteil (50) und das lineare Teil (48) zwischen dem ersten Führungsteil (44) und dem zweiten Führungsteil (46) angeordnet sind, das Blockierteil (50) eine Wand aufweist, die zwischen dem ersten Führungsteil (44) und dem linearen Teil (48) angeordnet ist, und das zweite Führungsteil (46) eine geneigte Fläche oder eine Bogenfläche aufweist.

## Revendications

1. Ensemble de glissière (22), comprenant:
un premier rail (28) comprenant un élément de libération (38);
un deuxième rail (30) mobile par rapport au premier rail (28);
un troisième rail (32) mobile par rapport au deuxième rail (30); et
un élément d'engagement (58) pivoté sur le deuxième rail (30);
dans lequel l'élément d'engagement (58) s'engage avec le troisième rail (32) pour permettre au deuxième rail (30) et au troisième rail (32) d'être déplacés de manière synchrone par rapport au premier rail (28) le long d'une première direction, et l'élément de libération (38) désengage l'élément d'engagement (58) du troisième rail (32) lorsque le deuxième rail (30) est déplacé de manière synchrone avec le troisième rail (32) par rapport au premier rail (28) vers une position prédéterminée;
dans lequel le troisième rail (32) a une pluralité de trous de montage (88a, 88b, 88c) espacés les uns des autres, et le troisième rail (32) comprend un élément d'extension (89) pour définir une partie de trou vertical (87) et une partie de trou longitudinal (85) du trou de montage (88a, 88b, 88c), la partie de trou longitudinal (85) est mise en communication avec la partie de trou vertical (87);
dans lequel un dispositif auxiliaire coulissant (74) est disposé entre le deuxième rail (30) et le troisième rail (32), le dispositif auxiliaire coulissant (74) comprend une base de maintien (76) et une pluralité d'éléments roulants (78) disposés sur la base de maintien (76), la pluralité d'éléments roulants (78) sont en contact roulant avec le deuxième rail (30) et le troisième rail (32);
dans lequel une première pièce d'actionnement (90) est montée sur le troisième rail (32), la première pièce d'actionnement (90) est commutée de manière opérationnelle entre un premier état de travail et un deuxième état de travail, le deuxième rail (30) comprend un élément de blocage (70) ayant une section de blocage (72), lorsque l'élément d'engagement (58) est désengagé du troisième rail (32) par l'élément de libération (38), et que le troisième rail (32) est déplacé par rapport au deuxième rail (30) le long de la première direction vers une position d'extension, la première pièce de fonctionnement (90) bute contre un côté de la section de blocage (72) de l'élément de blocage (70) dans le premier état de fonctionnement;
dans lequel le deuxième rail (30) a une première ouverture (59) et le dispositif auxiliaire coulissant (74) a une deuxième ouverture (79), lorsque le troisième rail (32) est situé à la position d'extension, la première ouverture (59), la deuxième ouverture (79) et l'un des trous de montage (88a, 88b, 88c) du troisième rail (32) sont en communication les uns avec les autres, et lorsque la première pièce de fonctionnement (90) est commutée de manière opérationnelle du premier état de fonctionnement au deuxième état de fonctionnement, le troisième rail (32) peut être détaché du deuxième rail (30) le long de la première direction.

2. Ensemble de glissière de la revendication 1, **caractérisé en ce que**
lorsque le troisième rail (32) est déplacé par rapport au deuxième rail (30) le long de la première direction d'une position rétractée à une première position prédéterminée, l'élément d'engagement (58) s'engage avec le troisième rail (32) pour permettre au deuxième rail (30) et au troisième rail (32) d'être déplacés de manière synchrone par rapport au premier rail (28) le long de la première direction;
lorsque le deuxième rail (30) est déplacé de manière synchrone avec le troisième rail (32) par rapport au premier rail (28) le long de la première direction jusqu'à une deuxième position prédéterminée, l'élément de libération (38) désengage l'élément d'engagement (58) du troisième rail (32) pour permettre au troisième rail (32) d'être déplacé par rapport au deuxième rail (30) le long de la première direction jusqu'à la position d'extension.

3. Ensemble de glissière selon la revendication 2, **caractérisé en ce que** l'ensemble de glissière (22) comprend en outre un élément élastique (62) fournissant une force élastique à l'élément d'engagement (58), et lorsque le troisième rail (32) est situé à la position rétractée par rapport au deuxième rail (30), l'élément d'engagement (58) bute contre la première paroi (80a) pour être maintenu dans un premier état en réponse à la force élastique de l'élément élastique (62).

4. Ensemble de glissière selon la revendication 3, **caractérisé en ce que** le troisième rail (32) a une ouverture (84) et une paroi de rail (86) adjacente à l'ouverture (84), l'élément d'engagement (58) comprend une partie d'engagement (64), et lorsque le troisième rail (32) est situé à la première position prédéterminée par rapport au deuxième rail (30), l'élément d'engagement (58) est tourné par rapport au deuxième rail (30) du premier état à un deuxième état en réponse à la force élastique de l'élément élastique (62), de sorte que la partie d'engagement (64) entre dans l'ouverture (84) pour correspondre à la paroi de rail (86).

5. Ensemble de glissière de l'une quelconque des revendications 2 à 4, **caractérisé en ce que** le deuxième rail (30) comporte un trou traversant (56) tourné vers le premier rail (28), l'élément d'engagement (58) comprend une partie d'extension (66) passant à travers le trou traversant (56), l'élément de libération (38) comprend une première partie de guidage (44), lorsque le deuxième rail (30) est déplacé de manière synchrone avec le troisième rail (32) le long de la première direction vers la deuxième position prédéterminée, l'élément d'engagement (58) est guidé par la première partie de guidage (44) à travers la partie d'extension (66) pour ne plus être dans le deuxième état, de manière à permettre à l'élément d'engagement (58) d'être désengagé du troisième rail (32), la première partie de guidage (44) a une face inclinée ou une face en arc.

6. Ensemble de glissière selon la revendication 5, **caractérisé en ce que** l'élément de libération (38) comprend en outre une partie de blocage (50), lorsque le deuxième rail (30) est déplacé par rapport au premier rail (28) de la deuxième position prédéterminée à une troisième position prédéterminée le long d'une deuxième direction opposée à la première direction, la partie d'extension (66) de l'élément d'engagement (58) est bloquée par la partie de blocage (50) pour empêcher le deuxième rail (30) d'être déplacé par rapport au premier rail (28) le long de la deuxième direction.

7. Ensemble de glissière selon la revendication 6, **caractérisé en ce que** pendant un processus de déplacement du troisième rail (32) par rapport au deuxième rail (30) le long de la deuxième direction à partir de la position d'extension, le troisième rail (32) entraîne l'élément d'engagement (58) pour déplacer la partie d'extension (66) de l'élément d'engagement (58) afin qu'elle ne soit plus bloquée par la partie de blocage (50).

8. Ensemble de glissière selon la revendication 6 ou 7, **caractérisé en ce que** l'élément de libération (38) comprend en outre une deuxième partie de guidage (46) et une partie linéaire (48), la partie de blocage (50) et la partie linéaire (48) sont situées entre la première partie de guidage (44) et la deuxième partie de guidage (46), dans lequel la partie de blocage (50) a une paroi située entre la première partie de guidage (44) et la partie linéaire (48), la deuxième partie de guidage (46) a une face inclinée ou une face en arc.
